# EUROPÄISCHE PATENTSCHRIFT

(11) **EP 0 443 070 B1**
(45) Veröffentlichungstag und Bekanntmachung des Hinweises auf die Patenterteilung: **20.09.1995**
(21) Anmeldenummer: 90103503.0
(22) Anmeldetag: 23.02.1990
(51) Int. Cl.: G06F 12/06, G06F 11/20

(54) **Anordnung zum Prüfen der Funktionsfähigkeit von Speicherplätzen eines Schreib-Lese-Speichers**
Device for verifying the correct functioning of memory locations in a read-write-memory
Dispositif de contrôle du bon fonctionnement des cellules de mémoire dans une mémoire vivante

(43) Veröffentlichungstag der Anmeldung: 28.08.1991
(73) Patentinhaber: SCHEIDT & BACHMANN GMBH, D-41238 Mönchengladbach (DE)
(72) Erfinder: Ehl, Rolf Josef, D-4050 Mönchengladbach 1 (DE); Schürmans, Peter, Dipl.-Ing., D-4050 Mönchengladbach 4 (DE)
(74) Vertreter: Stenger, Watzke & Ring Patentanwälte

(56) Entgegenhaltungen:
- WO-A-80/00383
- PATENT ABSTRACTS OF JAPAN Band 6, Nr. 206 (P-149)(1084), 19. Oktober 1982; & JP-A-57111900 (FUJITSU K.K.) 12.07.1982

## Beschreibung

### Anordnung zum Prüfen der Funktionsfähigkeit von Speicherplätzen eines Schreib-Lese-Speichers

Die Erfindung betrifft eine Anordnung zum Prüfen der Funktionsfähigkeit von vorzugsweise sicherheitsrelevanten Speicherplätzen eines Schreib-Lese-Speichers (RAM) innerhalb eines Computers, vorzugsweise eines Mikrocomputers, dessen CPU über einen Daten- und Adreßbus mit dem Schreib-Lese-Speicher (RAM) verbunden ist.

Es ist bekannt, die Funktionsfähigkeit von Schreib-Lese-Speichern innerhalb eines Computers mittels der verschiedensten Testprogramme zu prüfen. Hierbei ist eine Prüfung allerdings nur partiell und sequentiell möglich, sobald der Schreib-Lese-Speicher als Arbeitsspeicher verwendet wird. Dies bedeutet, daß komplexe Fehler des Schreib-Lese-Speichers, wie insbesondere Adressierungs- und Verknüpfungsfehler sowie Mehrfachzugriffe nicht erkannt werden können. Es besteht zwar die Möglichkeit, in Prozeßpausen per Software aus gewissen Bereichen des als Arbeitsspeicher dienenden Schreib-Lese-Speichers Daten auszulagern und diese Bereiche zu testen; diese Testmöglichkeit ist jedoch nicht gegeben, wenn es sich aus prozeßablauftechnischen Gründen um Speicherplätze für Programme handelt, die für Programmunterbrechungen (Interrupts) stets zur Verfügung stehen müssen.

Zür Erhöhung der Funktionssicherheit ist aus PATENT ABSTRACTS OF JAPAN 3 and 6, Nr. 206 (P-149)(1084), 19.10.1982 bekannt ein Hauptspeichersystem bestehend aus einem regulären Speicher (z.B. MMU0) und einem Ersatzspeicher (z.B. MMU1), wobei wahlweise einer der beiden Speicher verwendet wird. Dies ist möglich, da zwar nur aus einem Speicher gelesen wird, aber immer in beide Speicher geschrieben wird.

Um die Funktionssicherheit eines Computers zu erhöhen, ist es weiterhin bekannt, das gesamte Computersystem zu vervielfachen und die Ausgangssignale und Daten der parallelarbeitenden Computersysteme vor der Verarbeitung miteinander zu vergleichen. Durch eine derartige Vervielfachung läßt sich jedoch nicht ausschließen, daß bei über einen längeren Zeitraum gespeicherten Daten unter Annahme realistischer Ausfallraten der Hardware in allen Systemen gleiche Datenveränderungen aufgetreten sind. Diese mögliche Verfälschung der Daten ist insbesondere kritisch bei sicherheitsrelevanten Anwendungen, z.B. bei der Steuerung von Verkehrssignalanlagen und in der Kernkrafttechnik.

Der Erfindung liegt die Aufgabe zugrunde, eine Anordnung der eingangs beschriebenen Art zu schaffen, mit der unabhängig vom Prozeßverlauf, d.h. auch bei Interrupt-Verarbeitung, jederzeit und ohne zeitliche Beschränkung eine beliebig komplexe Prüfung des Schreib-Lese-Speichers möglich ist.

Die Lösung dieser Aufgabenstellung durch die Erfindung ist wie im Anspruch 1 dargestellt.

Durch die parallele Verwendung von zwei physikalisch getrennten Schreib-Lese-Speichern, die über denselben Daten- und Adreßbus von einer gemeinsamen CPU betrieben werden, ergibt sich mit der Erfindung die Möglichkeit, mit Hilfe einer von der CPU ansteuerbaren Steuerlogik die beiden Schreib-Lese-Speicher wahlweise und abwechselnd als Arbeitsspeicher bzw. als zu testender Speicher zu benutzen. Um hierbei jederzeit die volle Funktionsfähigkeit der Prozeßablaufsteuerung in bezug auf die gespeicherten Daten sicherzustellen, werden zwischen den zeitlich aufeinanderfolgenden Wechseln der Schreib-Lese-Speicher zu Arbeits- bzw. Testzwecken die fortlaufend anfallenden Prozeßdaten in beide Schreib-Lese-Speicher parallel eingeschrieben, wogegen Leseoperationen nur aus dem jeweils als Arbeitsspeicher dienenden Schreib-Lese-Speicher erfolgen. Damit gewährleistet ist, daß vor einem Wechsel die Dateninhalte beider Schreib-Lese-Speicher identisch sind, wird der noch als Arbeitsspeicher dienende Schreib-Lese-Speicher mit Hilfe der CPU sequentiell vollständig ausgelesen und die Daten in beide Schreib-Lese-Speicher zurückgeschrieben. Erst wenn alle Daten des als Arbeitsspeicher dienenden Schreib-Lese-Speichers auf diese Weise in den zuvor getesteten Speicher eingelesen worden sind, erfolgt mittels der Steuerlogik eine Umschaltung der Schreib-Lese-Speicher bezüglich ihrer Funktion als Arbeitsspeicher bzw. als zu Testzwecken bereitstehender Speicher. Ein derartiger Aufwand ist aus wirtschaftlichen Gründen nur für solche Speicherbereiche vertretbar, die sicherheitsrelevant sind.

Um einen ordnungsgemäßen Wechsel der beiden physikalisch voneinander getrennten Schreib-Lese-Speicher in ihrer Funktion als Arbeits- bzw. Testspeicher feststellen zu können, wird in Weiterbildung der Erfindung vorgeschlagen, einen Teil des Speicherbereiches des jeweiligen Arbeitsspeichers mit einem Prüfmuster zu versehen, das vom Auslesen und Wiederzurückschreiben beim Wechsel der Schreib-Lese-Speicher ausgenommen und erst nach erfolgter Überprüfung der Umschaltung mit Hilfe dieses Prüfmusters in den jeweils neuen Arbeitsspeicher übertragen wird.

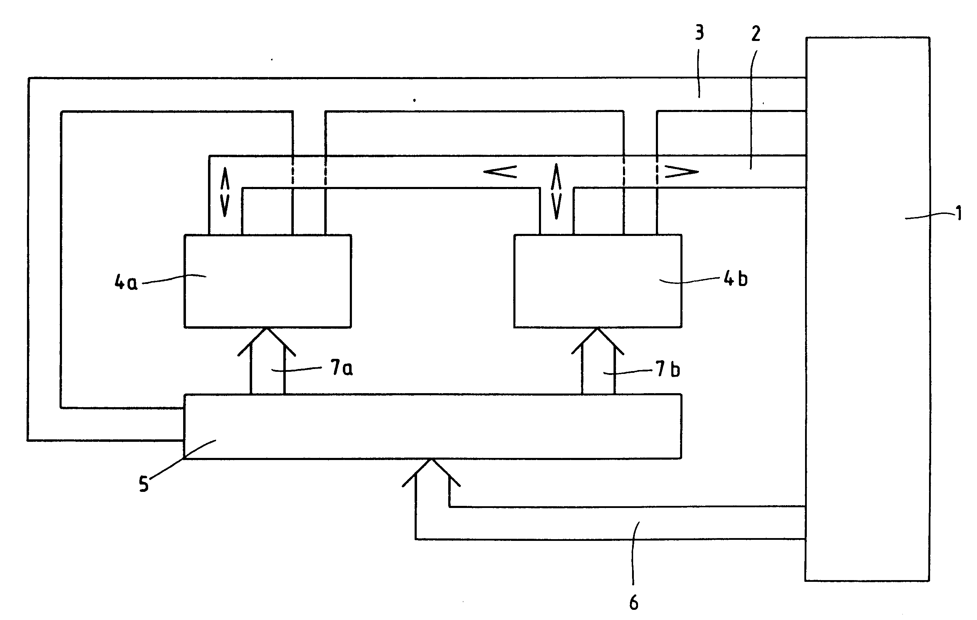

Auf der Zeichnung ist ein Ausführungsbeispiel der erfindungsgemäßen Anordnung anhand eines Blockschaltdiagramms dargestellt.

Der dargestellte Teil eines Computers umfaßt eine CPU 1, die über einen Datenbus 2 und einen Adreßbus 3 mit zwei physikalisch voneinander getrennten Schreib-Lese-Speichern 4a und 4b verbunden ist. Die Zugriffe auf diese Schreib-Lese-Speicher 4a und 4b erfolgen über eine von der CPU 1 betriebene Steuerlogik 5. Im Diagramm sind außer zwischen der CPU 1 und der Steuerlogik 5 verlaufenden Steuersignalen 6 (beispielsweise read-write-Berechtigungen) die Schreib- bzw. Leseberechtigungen (read-write) 7a bzw. 7b zwischen Steuerlogik 5 und jedem der Schreib-Lese-Speicher 4a und 4b dargestellt. Außerdem ist die Steuerlogik 5 über den Adreßbus 3 mit der CPU 1 verbunden.

Es wird angenommen, daß der Schreib-Lese-Speicher 4a als Arbeitsspeicher benutzt wird, während der Schreib-Lese-Speicher 4b gleichzeitig einem komplexen Testprogramm unterworfen wird. Die Adressen für den Schreib-Lese-Speicher 4a sind über die Steuerlogik 5 auf den Bereich x₁ bis xₙ festgelegt; für den Schreib-Lese-Speicher 4b gelten die Adressen y₁ bis y_{n.} Die anfallenden bzw. benötigten Prozeßdaten werden in diesem Zustand von der CPU 1 über den Datenbus 2 aus dem Schreib-Lese-Speicher 4a mit dem Adreßbereich x₁ bis xₙ ausgelesen bzw. eingeschrieben.

Wenn das den Adreßbereich y₁ bis yₙ betreffende Testprogramm des Schreib-Lese-Speichers 4b beendet ist, wird mit Hilfe der Steuersignale 6 die Steuerlogik 5 so umgeschaltet, daß die Lesezugriffe der CPU 1 auf den Bereich x₁ bis xₙ weiterhin auf den Schreib-Lese-Speicher 4a erfolgen, daß aber Schreibzugriffe der CPU 1 auf den Bereich x₁ bis xₙ gleichzeitig auch auf den Schreib-Lese-Speicher 4b erfolgen. Die Steuerlogik 5 sorgt somit dafür, daß in diesem Zustand die Daten für den Adreßbereich x₁ bis xₙ nicht nur in den Schreib-Lese-Speicher 4a, sondern auch in den Schreib-Lese-Speicher 4b eingeschrieben werden, obwohl dieser zur Zeit den Lese-Adreßbereich y₁ bis yₙ hat. In diesem Zustand zwischen dem Wechsel der Schreib-Lese-Speicher 4a und 4b als Arbeits- bzw. Testspeicher werden von der CPU 1 sämtliche Daten des Adreßbereiches x₁ bis xₙ aus dem derzeitigen Arbeitsspeicher 4a ausgelesen und anschließend zurückgeschrieben. Da Schreibzugriffe in diesem Zustand auf beide Schreib-Lese-Speicher 4a und 4b erfolgen, ergibt sich ein identischer Dateninhalt in beiden Schreib-Lese-Speichern 4a und 4b.

Sobald der gesamte Adreßbereich x₁ bis xₙ ausgegeben und wieder eingeschrieben worden ist, kann ein Wechsel dadurch erfolgen, daß nunmehr über die Steuersignale 6 die Steuerlogik 5 so umgeschaltet wird, daß jetzt der Schreib-Lese-Speicher 4b als Arbeitsspeicher dient und der Schreib-Lese-Speicher 4a getestet wird. Die CPU 1 greift nunmehr mit dem Testzwecken dienenden Adreßbereich y₁ bis yₙ auf den Schreib-Lese-Speicher 4a zu, wogegen der Arbeitszwecken dienende Schreib-Lese-Speicher 4b dem Adreßbereich x₁ bis xₙ zugeordnet ist.

Aufgrund der voranstehend beschriebenen Anordnung ist es somit möglich, ohne Unterbrechung der Prozeßsteuerung sämtliche relevante Speicherplätze eines Schreib-Lese-Speichers einem komplexen Testprogramm zu unterziehen und so die Funktionssicherheit des Schreib-Lese-Speichers zu prüfen, und zwar auch dann, wenn der Prozeßverlauf eine Interrupt-Verarbeitung jederzeit sicherstellen muß.

Um zu prüfen, ob die Umschaltung zwischen den physikalisch getrennten Schreib-Lese-Speichern 4a und 4b ordnungsgemäß erfolgt ist, wird in einem definierten Adreßteilbereich von x₁ bis xₙ ein Prüfmuster eingetragen. Dieser Adreßteilbereich wird während des Zwischenzustandes zwischen den Wechseln des Arbeits- und Testbereiches vom Auslesen und parallelen Einschreiben der Daten ausgenommen. Die Daten des Prüfmusters stehen somit nach erfolgter Umschaltung im jetzigen Testspeicher noch zur Verfügung, so daß über dieses Prüfmuster festgestellt werden kann, ob die Umschaltung der beiden physikalisch getrennten Schreib-Lese-Speicher 4a und 4b ordnungsgemäß erfolgt ist. Sobald dies festgestellt worden ist, wird dieses Prüfmuster in den neuen Arbeitsspeicher übernommen. Der neue Testspeicher steht dann im gesamten Adreßbereich y₁ bis yₙ zu Testzwecken zur Verfügung.

### Bezugszeichenliste:

- 1: CPU
- 2: Datenbus
- 3: Adreßbus
- 4a: Schreib-Lese-Speicher
- 4b: Schreib-Lese-Speicher
- 5: Steuerlogik
- 6: Steuersignale
- 7a: Schreib- bzw. Leseberechtigung
- 7b: Schreib- bzw. Leseberechtigung

## Patentansprüche

1. Anordnung zum Prüfen der Funktionsfähigkeit von vorzugsweise sicherheitsrelevanten Speicherplätzen eines Schreib-Lese-Speichers (RAM) (4a bzw. 4b) innerhalb eines Computers, vorzugsweise eines Mikrocomputers, dessen CPU (1) über einen Daten- und Adreßbus (2,3) mit dem Schreib-Lese-Speicher (RAM) (4a bzw. 4b) verbunden ist,
wobei eine der Anzahl der Speicherplätze entsprechende Anzahl von Speicherplätzen auf einem physikalisch getrennten Schreib-Lese-Speicher (4b bzw. 4a) zur Verfügung gestellt wird, der über denselben Daten- und Adreßbus (2,3) von derselben CPU (1) betrieben wird,
wobei die Ansteuerung dieser Speicherplätze beider Schreib-Lese-Speicher (4a,4b) durch eine gemeinsame Steuerlogik (5) derart erfolgt, daß beide Speicherbereiche als getrennt ansprechbare Speicher benutzbar sind, von denen wahlweise ein Speicherbereich als Arbeitsspeicher benutzt wird, während der andere Speicherbereich einem Prüfprogramm unterzogen wird,
wobei nach Beendigung dieses Prüfprogramms die Schreiboperationen der fortlaufend anfallenden Prozeßdaten parallel in beide Speicherbereiche erfolgen, während Leseoperationen weiterhin nur aus dem gerade als Arbeitsspeicher dienenden Speicherbereich erfolgen
wobei sobald alle Daten aus dem jeweils als Arbeitsspeicher dienenden Speicherbereich in den getesteten Speicherbereich durch Auslesen und Wiederzurückschreiben des gesamten Arbeitsspeichervolumens mit Hilfe der CPU (1) übernommen worden sind, ein Wechsel der beiden Speicherbereiche erfolgen kann.

2. Anordnung nach Anspruch 1, dadurch gekennzeichnet, daß ein Teil des Speicherbereiches (x₁ bis xₙ) des jeweiligen Arbeitsspeichers (4a bzw. 4b) mit einem Prüfmuster versehen ist, das vom Auslesen und Wiederzurückschreiben beim Wechsel der Schreib-Lese-Speicher (4a und 4b) ausgenommen und erst nach erfolgter Überprüfung der Umschaltung mit Hilfe dieser Prüfmuster in den jeweils neuen Arbeitsspeicher übertragen wird.

## Claims

1. Device for verifying the correct functioning of preferably security-relevant memory locations in a read-write memory (RAM) (4a and 4b) within a computer, preferably a microcomputer, the CPU (1) of which is connected via a data and address bus (2, 3) to the read-write memory (RAM) (4a and 4b), a number of memory locations corresponding to the number of abovementioned memory locations being made available on a physically separate read-write memory (4b or 4a), which is operated via the same data and address bus (2, 3) by the same CPU (1), the selecting of these memory locations of both read-write memories (4a, 4b) being performed by a common control logic (5) in such a way that both memory areas can be used as separately addressable memories, of which, according to choice, one memory area is used as the main memory while the other memory area is subjected to a test programme, after completion of this test programme the write operations of the continuously generated process data being performed in parallel into both memory areas, while read operations continue to be performed only from the memory area serving at that time as the main memory, a change of the two memory areas being able to take place as soon as all the data from the memory area respectively serving as the main memory have been taken over into the tested memory area by reading out and writing back the entire volume of the main memory with the aid of the CPU (1).

2. Device according to Claim 1, characterized in that part of the memory area (x₁ to xₙ) of the respective main memory (4a or 4b) is provided with a test pattern, which is excluded from the reading out and writing back when changing the read-write memories (4a and 4b) and is transferred into the respectively new main memory only after verification of the switching-over has taken place with the aid of these test patterns.

## Revendications

1. Agencement destiné à tester le bon fonctionnement d'emplacements de mémoire, de préférence importants pour la sécurité de fonctionnement, d'une mémoire de lecture-écriture (mémoire vive ou "RAM") (4a ou respectivement 4b) à l'intérieur d'un ordinateur, notamment d'un micro-ordinateur, dont l'unité centrale de traitement ou "CPU" (1) est reliée à la mémoire de lecture-écriture ("RAM") (4a ou respectivement 4b) par l'intermédiaire d'un bus de données et d'adresses (2, 3), un nombre d'emplacements de mémoire, correspondant au nombre d'emplacements de mémoire considérés, étant prévus sur une mémoire de lecture-écriture (4b ou respectivement 4a) physiquement séparée, dont l'exploitation se fait par la même unité centrale de traitement ou "CPU" (1), par l'intermédiaire du même bus de données et d'adresses (2, 3), la commande de ces emplacements de mémoire des deux mémoires de lecture-écriture (4a, 4b) s'effectuant par une logique de commande (5) commune, de manière telle, que les deux zones de mémoire puissent être utilisées en tant que mémoires adressées séparément, l'une des zones de mémoire étant utilisée sélectivement en tant que mémoire de travail, pendant que l'autre zone de mémoire est soumise à un programme de test, les opérations d'écriture des données opératoires qui affluent en continu, s'effectuant, après la fin de ce programme de test, en parallèle dans les deux zones de mémoire, tandis que les opérations de lecture ne s'effectuent toujours qu'à partir de la zone de mémoire servant justement de mémoire de travail, et un échange des deux zones de mémoire s'effectuant dès que toutes les données de la zone de mémoire servant actuellement de mémoire de travail, ont été transférées dans la zone de mémoire ayant été testée, par lecture et nouvelle réécriture de la totalité du volume de la mémoire de travail, à l'aide de l'unité centrale de traitement ou "CPU" (1).

2. Agencement selon la revendication 1, caractérisé en ce qu'une partie de la zone de mémoire (x₁ à xₙ) de la mémoire de travail actuelle (4a ou respectivement 4b) est pourvue d'un modèle de test, qui est exclu de la lecture et de la nouvelle réécriture lors de l'échange dès mémoires de lecture-écriture (4a et 4b), et qui n'est transféré dans la nouvelle mémoire de travail respective, qu'après le test réussi de la commutation à l'aide de ce modèle de test.
